# EUROPÄISCHE PATENTSCHRIFT

(11) **EP 1 854 257 B1**
(45) Veröffentlichungstag und Bekanntmachung des Hinweises auf die Patenterteilung: **22.07.2009**
(21) Anmeldenummer: 06706795.9
(22) Anmeldetag: 09.02.2006
(51) Int. Cl.: H04L 25/49, H03M 5/12, H04L 12/413

(54) **BUSSYSTEM UND VERFAHREN ZUM BETREIBEN DES BUSSYSTEMS**
BUS SYSTEM AND METHOD FOR OPERATING THE SAME
SYSTEME DE BUS ET PROCEDE POUR FAIRE FONCTIONNER UN SYSTEME DE BUS

(30) Priorität: 02.03.2005 DE 102005009495; 25.07.2005 DE 102005034652
(43) Veröffentlichungstag der Anmeldung: 14.11.2007
(60) Teilanmeldung: 08010188.4
(73) Patentinhaber: Rohde & Schwarz GmbH & Co. KG, 81671 München (DE)
(72) Erfinder: HUBER, Martin, 85456 Wartenberg (DE); KOEHLER, Hendrik, 85399 Hallbergmoos (DE)
(74) Vertreter: Körfer, Thomas
(86) Internationale Anmeldenummer: PCT/EP2006/001161
(87) Internationale Veröffentlichungsnummer: WO 2006/092201

(56) Entgegenhaltungen:
- WO-A-20/04066576
- US-A- 4 022 973
- US-A- 5 550 864
- US-A- 5 687 356
- US-A1- 2002 083 233
- US-A1- 2005 256 969
- US-B1- 6 205 119
- US-B1- 6 504 849
- US-B1- 6 697 874

## Beschreibung

Die vorliegende Erfindung betrifft ein Bussystem, insbesondere einen Seriellen Radio Controlled Bus (RCBSER), der z. B. externe Antennenanpaßgeräte, Verstärker und Filter u. s. w. in Echtzeit ansteuern soll.

Standardmäßig findet in einem seriellen Bussystem eine Nachrichtenverarbeitung basierend auf einer gespeicherten Weiterleitung von Nachrichten statt. Die Nachrichten werden von Busknoten zu Busknoten weitergereicht, wobei Nachrichten des aktuellen, verarbeitenden Busknotens bevorzugt berücksichtigt werden. Bei dieser Art der knotenweisen Weiterleitung von Nachrichten kann keine Echtzeitfähigkeit hergestellt werden, da die Verweilzeit einer Nachricht in den Speichern der Busknoten nicht voraussagbar ist, sondern allerhöchstens statistisch angegeben werden kann.

Im Gegensatz zu synchronen Bussen, bei denen ein spezieller Knoten eine gewisse Portion eines synchronen Kanals für eine gewisse Zeit zugeordnet bekommt, ermöglicht eine asynchrone Ansteuerung die Weitergabe von mehreren Anforderungen kleiner Datenmengen, ohne dass ein Abbruch einer Nachrichtenübertragung stattfinden muß. In der US 5,719,858 und der EP 1 465 370 A1 werden Systeme vorgeschlagen die eine asynchrone Übertragung auf der Basis eines synchronen physikalischen Kanals erlauben. Dadurch wird es ermöglicht eine Umgebung für die Kommunikation zweier Knoten bereitzustellen, die auch hohen Anforderungen bzgl. der Zeitbedingungen genügt. So sind bei der US 5,719,858 mehrere Knoten an einem TDM (time division multiplexed) Bus angeschlossen, an dem eine gewisse Bandbreite mehreren Busknoten zur Verfügung gestellt wird. Diese wird dann in einem Zeitscheibenverfahren auf die einzelnen Einheiten verteilt. In der EP 1 465 370 A1 wird ein Datentelegramm zur asynchronen Verarbeitung aufgeteilt und in sogenannte 'clocked frames' eingepackt, so dass es möglich wird, eine synchrone Datenübertragung auf einem synchronen Bus zu ermöglichen.

Das Manchester-Kodierungsverfahren hat sich als StandardMethode für Bus-Systeme etabliert, siehe z.B. US 5 687 356. Es ist einfach zu implementieren, gleichstromfrei und ermöglicht die Selbstsynchronisation miteinander kommunizierender Stationen, sodass eine separate Taktversorgung entfällt.

Die Aufgabe der vorliegenden Erfindung ist es, die Kommunikation in einem Bussystem zu beschleunigen und damit dessen Echtzeitfähigkeit zu verbessern.

Die Aufgabe wird durch ein Bussystem mit den Merkmalen des Anspruchs 1 gelöst.

In dem seriellen Bussystem können Bitinformationen in Echtzeit zwischen den Einheiten über ein Synchronisationssignal ausgetauscht werden und parallel dazu Nachrichten größerer Länge asynchron weitergereicht werden.

In dem Bussystem wird dabei eine Zentrale oder ein ausgezeichneter Busknoten als übergeordnete Einheit bezeichnet, die über einen Bus mit mehreren anderen Busknoten, untergeordneten Einheiten, verbunden ist und über diesen kommunizieren.

Insbesondere werden zwischen den einzelnen Einheiten ständig Synchronisations-Signale ausgetauscht, mit denen zeitkritische Signale von Einheit zu Einheit übertragen werden. Parallel dazu können, asynchron und völlig unabhängig von den Synchronisations-Signalen, Nachrichten einer endlichen Länge zwischen den einzelnen Einheiten versendet bzw. ausgetauscht werden.

Vorteilhafte Weiterbildungen gehen aus den Unteransprüchen hervor.

Zusätzlich zu der Adress- und Dateninformation wird bekanntlich an Datentelegrammen innerhalb von Nachrichtensystemen ein Kopf angehängt, der im vorliegenden Fall die Synchronisierung des Empfängers auf den Empfang einer Nachricht ermöglicht. Ein solches Telegramm wird in der nachfolgend beschriebenen Realisierung z. B. durch 24 Felder repräsentiert, wobei 13 Felder auf die Adressinformation entfallen und 8 Felder auf Daten. Die 13 Felder der Adressinformation sprechen dabei nicht nur die Adressen der einzelnen untergeordneten Einheiten an, sondern bestimmen auch den angesprochenen bzw. den zu modifizierenden Parameter innerhalb des jeweiligen Zusatzgerätes.

Der Kopf der Nachricht zeigt nicht nur den Beginn einer Nachricht an, sondern er dient auch zur Synchronisation der Einheiten. Diese Zeichenfolge, auch Synchronwort genannt, dient dem Empfänger dazu, den Beginn des nachfolgenden Datenwortes zu erkennen.

Für eine initiale Synchronisation der einzelnen Einheiten untereinander wird zunächst ein sogenannter Synchronisationsframe gesendet. Dieser sorgt für die gegenseitige Abgleichung eines gemeinsamen Taktes und die Zuordnung der Felder einer Nachricht zu deren Kodierung. Werden keine Nachrichten oder Datentelegramme versendet, werden ständig Synchronisationsframes von einer Einheit an die nächste gesendet. Diese sorgen ebenfalls für die Synchronisierung der Taktgeneratoren.

Der Austausch von Informationen in Echtzeit basiert auf dem ständig ausgetauschten Bit- bzw. Taktsignal zwischen den einzelnen Einheiten. Bei der erstmaligen Versendung des Synchronisationsframe wird die Zuordnung eines Zeichen 'X' zu '0' bzw. '1' und 'Y' zu '0' bzw. '1' festgelegt. Auf dem seriellen Bussystem wird diese Information an alle Einheiten weiterübertragen, sodass auf allen Verbindungsleitungen das gleiche Signal übertragen wird. Will eine Einheit an die übergeordnete Einheit eine Bit-Nachricht senden, so ändert diese auf dem Taktsignal die Zuordnung 'X' zu '0' bzw. '1' und/ oder Y zu '0' bzw. '1'. In der nachfolgenden Einheit wird dieses Signal mit dem eigenen Taktsignal in einem UND-Glied zu einem gemeinsamen Signal verknüpft und an die nächsthöherliegende Einheit gesendet. Auf diese Weise kann ein Bitsignal sehr schnell von Einheit zu Einheit und zu einem Master weiterübertragen werden. Ein von der Bitinformation unabhängiges Datenpaket wird Bit für Bit auf zwischenliegende Bitplätze verteilt, sodass neben dem Taktsignal asynchron Datenpakete versendet werden. So kann von Kanälen gesprochen werden, in denen zum einen ständig Bitinformation in Echtzeit ausgetauscht werden kann und zum anderen zeitlich verteilt eine längere Nachricht asynchron übertragen werden kann.

Die Echtzeitfähigkeit ist weiterhin dadurch gegeben, dass die Bitinformation nicht zwischengespeichert wird. Die Bitsignale werden als fortlaufendes Signal in den Einheiten durch eine UND-Verknüpfung mit dem intern generierten Bitsignal vereinigt und ohne Verzögerung umgesetzt. Datentelegramme müssen zunächst extrahiert und in einen Speicher in voller Länge eingelesen werden, um interpretiert zu werden.

Der Einsatz eines differentiellen Manchester Codes ermöglicht die Darstellung der Felder mit jeweils einem Bit, wodurch sich die Nachrichtenlänge zu 48 Bit ergibt und sich die Länge der Daten- und Adressinformation zu 8, respektive 13 Bits bestimmt. Die eingebrachten Abweichungen von der allgemein verwendeten Kodierungsweise, ermöglichen die Definition weiterer Zeichen, die ihrerseits die Definition weiterer Steuerzeichen ermöglicht. Abweichend von einem Standardalphabet, das die Zeichen 'K', 'J', '0' und '1' enthält, können durch die zusätzlichen Zeichen bzw. Steuersignale 'X', 'Y', 'READY', 'TX_ACTIVE' und 'CARRIER_MAGNITUDE' geschaffen werden.

Zur Weiterleitung der Nachrichten in den sequentiell z. B. über Koaxial- oder Glasfaserkabel verbundenen untergeordneten Einheiten wird in den Zusatzgeräten jeweils ein Speicher bereitgestellt, in dem Nachrichten vor ihrer Weiterleitung zwischengespeichert werden und so eine geregelte Nachrichtenübertragung von untergeordneter Einheit zu untergeordneter Einheit garantiert werden kann. Zusätzlich stellt eine entsprechende Logik die Mittel zur Verarbeitung der Nachrichten innerhalb einer untergeordneten Einheit bzw. zur Übergabe einer Nachricht an eine weitere untergeordnete Einheit bereit. Speicher und Logik werden z. B. mit Hilfe eines 'Programmable Gate Arrays' (FPGA-Bausteines) in den Geräten realisiert, womit die Möglichkeit gegeben ist, auf zukünftige Anforderungen an die Leistungsfähigkeit des Busses Rücksicht zu nehmen.

Durch den bereitgestellten integrierten Speicher und die Logik kann ein Kommunikationsablauf zur Behandlung von Standardnachrichten und zeitkritischen Nachrichten der folgenden Art bereitgestellt werden:
1.) Falls eine untergeordnete Einheit eine Nachricht empfängt, wird zunächst geprüft ob der interne Speicher bereits eine Nachricht enthält. Enthält der Speicher eine Nachricht, wird die ankommende Nachricht in den Speicher eingetragen und erst dann weitergeleitet, wenn alle zuvor angekommenen bzw. in den Speicher eingetragenen Nachrichten an die nachfolgenden untergeordneten Einheiten weitergesendet bzw. aus dem Speicher entnommen wurden.
2.) Wird eine Nachricht von einer untergeordneten Einheit empfangen und deren Speicher ist leer, so wird die Nachricht direkt weitergesendet.
3.) Wird von einer untergeordneten Einheit eine zeitkritische Nachricht empfangen, so wird der Zustand des Speichers nicht geprüft sondern direkt ein interner Zustand verifiziert und erst danach die Nachricht weitergesendet.
4.) Wird von einer untergeordneten Einheit eine TX_ACTIVE bzw. TX_ACTIVE/CARRIER_MAGNITUDE Nachricht von der übergeordneten Einheit empfangen so wird die Einstellung der untergeordneten Einheit nicht mehr verändert und ein interner Zustand gesetzt. Nach Empfang einer Nachricht von einer vorhergehenden, untergeordneten Einheit wird diese sofort an die nachfolgende untergeordnete Einheit weitergeleitet.

Durch diese generelle Nachrichteninfrastruktur wird es möglich, eine Basisfunktionalität bereitzustellen, bei der einzelne untergeordnete Einheiten, die mit den Anschlüssen des Busses verbunden sind, über einen seriellen Bus mit einer übergeordneten Einheit kommunizieren. Dabei kann eine Rückmeldung über die erfolgreiche Einstellung von Parametern gegeben oder der Zustand der untergeordneten Einheit bzw. Werte wie Temperatur an die übergeordnete Einheit weitergeleitet werden. Zusätzlich erlaubt die Übertragung eine Bitinformation über das ständig ausgetauschte Taktsignal den schnellen Austausch einer Informationseinheit in Echtzeit.

Die Erfindung wird nachfolgend unter Bezugnahme auf die Zeichnung näher beschrieben. In der Zeichnung zeigen:
- Fig. 1a: der Aufbau des seriellen Busses;
- Fig. 1b: den Aufbau einer untergeordneten Einheit;
- Fig. 2: eine Anwendung des Busses;
- Fig. 3: den Standardnachrichtenaufbau;
- Fig. 4: den Nachrichtenaufbau zur schnellen Übertragung von Nachrichten;
- Fig. 5: den Differentiellen Manchester Code;
- Fig. 6: das Zeitverhalten einer Nachricht zur schnellen Übertragung auf dem Bus;
- Fig. 7a: den Nachrichtenaustausch zwischen untergeordneten Einheiten in einer ersten Phase;
- Fig. 7b: den Nachrichtenaustausch zwischen untergeordneten Einheiten in einer zweiten Phase;
- Fig. 8a: den Nachrichtenaustausch zur schnellen Übertragung auf dem Bus in einer ersten Phase;
- Fig. 8b: den Nachrichtenaustausch zur schnellen Übertragung auf dem Bus in einer zweiten Phase;
- Fig. 9: den Nachrichtenaustausch zur schnellen Übertragung auf dem Bus in einer dritten Phase;
- Fig. 10: besondere zeitkritische Nachrichten;
- Fig. 11: das Zeitverhalten einer Nachrichtenübertragung in einer ersten Phase und
- Fig. 12: das Zeitverhalten einer Nachrichtenübertragung in einer zweiten Phase.

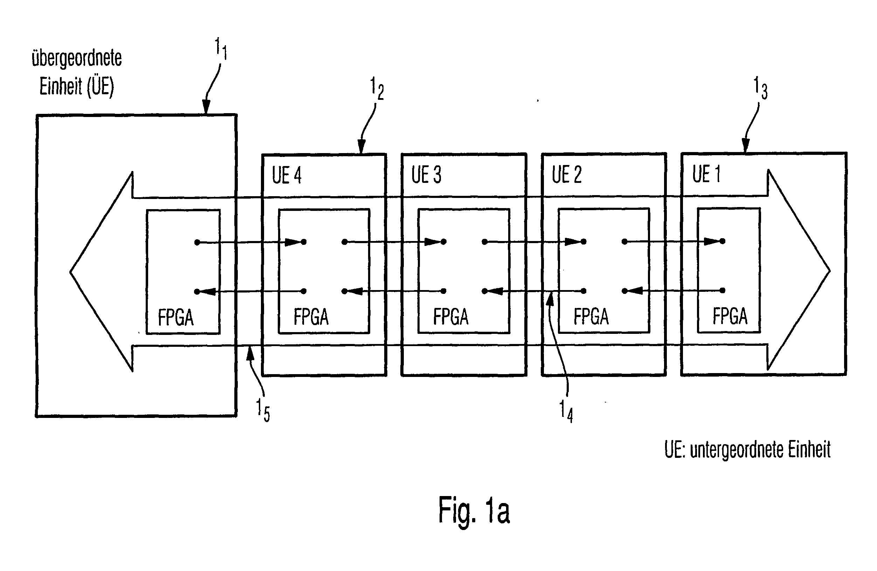

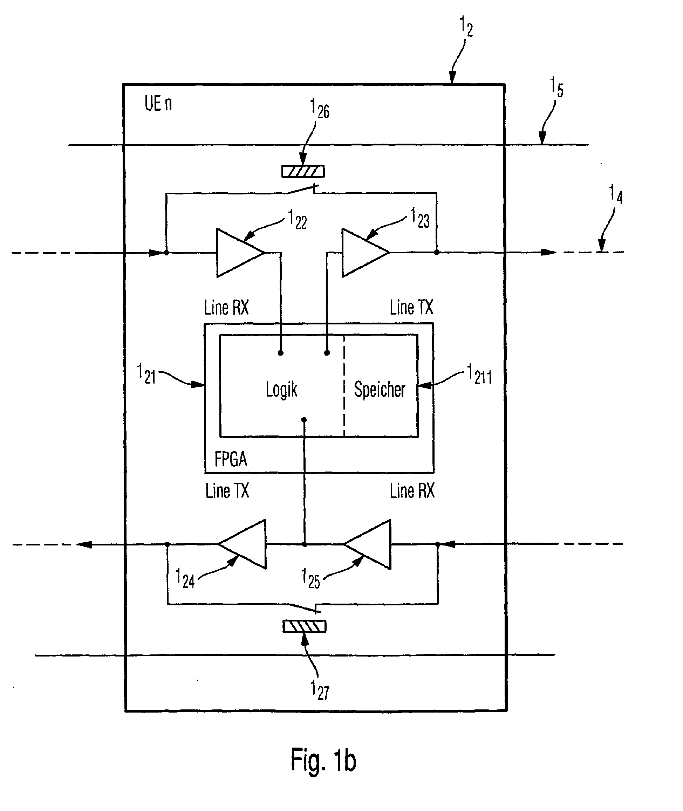

Der Aufbau des in Fig. 1a und Fig. 1b gezeigten Bussystems 1 ist durch eine übergeordnete Einheit 1₁, an die mehrere untergeordnete Einheiten 1₂, 1₃ angeschlossen werden können, gekennzeichnet. Die untergeordneten Einheiten 1₂, 1₃ werden dabei in Reihe oder Serie zu einem seriellen Aufbau verbunden. Dabei wird eine erste untergeordnete Einheit UE4, z.B. ein Preselektor, über zwei Kabel an eine übergeordnete Einheit ÜE, z. B. ein Funkgerät, angeschlossen, und danach eine zweite untergeordnete Einheit UE3, z.B. ein Stehwellenmeßgerät, über weitere zwei Kabel mit der ersten untergeordneten Einheit verbunden usw. Eine letzte untergeordnete Einheit UE1, z.B. ein Antennenanpaßgerät (Antenna Tuning Unit) schliesst den Bus 1₅ ab.

Zur Verkabelung 1₄ können statt der Koaxialkabel auch Glasfaserkabel und optische Verbinder verwendet werden, ohne den Busaufbau zu verändern. Obwohl das Bussystem 1 in erster Linie dafür ausgelegt ist, externe Module anzusteuern, ist das nachfolgend beschriebene Konzept auch offen für Anwendungen, die die Ansteuerung interner Module erfordern. Zur Vereinfachung wird für die Bezeichnung des Busses 1₅ auch die Abkürzung RCBSER verwendet. Zusätzlich muß noch erwähnt werden, dass jede Geräteeinheit 1₁, 1₂ bzw. 1₃ z. B. über ein Programmable Gate Array (FPGA-Baustein) verfügt, der einen Speicher 1₂₁₁ enthält und die Kommunikation über den Bus 1₅ steuert.

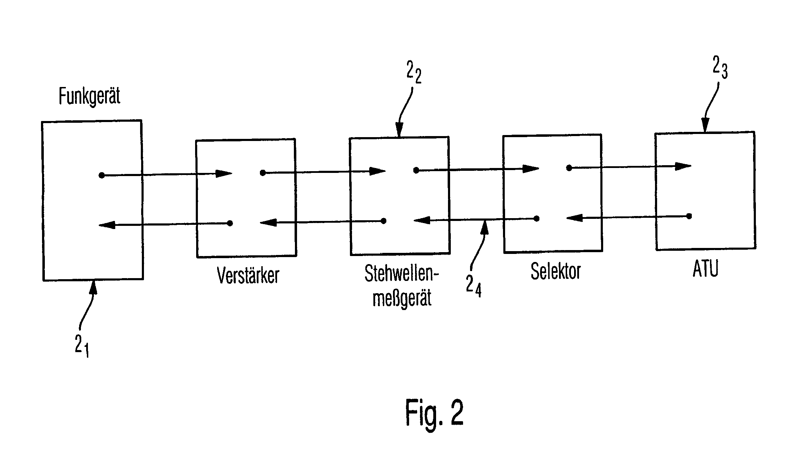

Eine in Fig. 2 gezeigte Anwendung des Bussystems 1, besteht in dem Aufbau eines Funksystems. Dabei bildet die übergeordnete Einheit 1₁ das Funkgerät 2₁ und die untergeordneten Einheiten 1₂ können Zusatzgeräte 2₂ wie Verstärker, Stehwellenmeßgeräte oder Selektoren sein, die an das Funkgerät z. B. über Koaxial- bzw. Glasfaserleitungen 2₄ angeschlossen sind. Das Bussystem 1 wird, z.B. durch ein automatisches Antennenanpaßgerät (Antenna Tuning Unit ATU), 2₃ abgeschlossen.

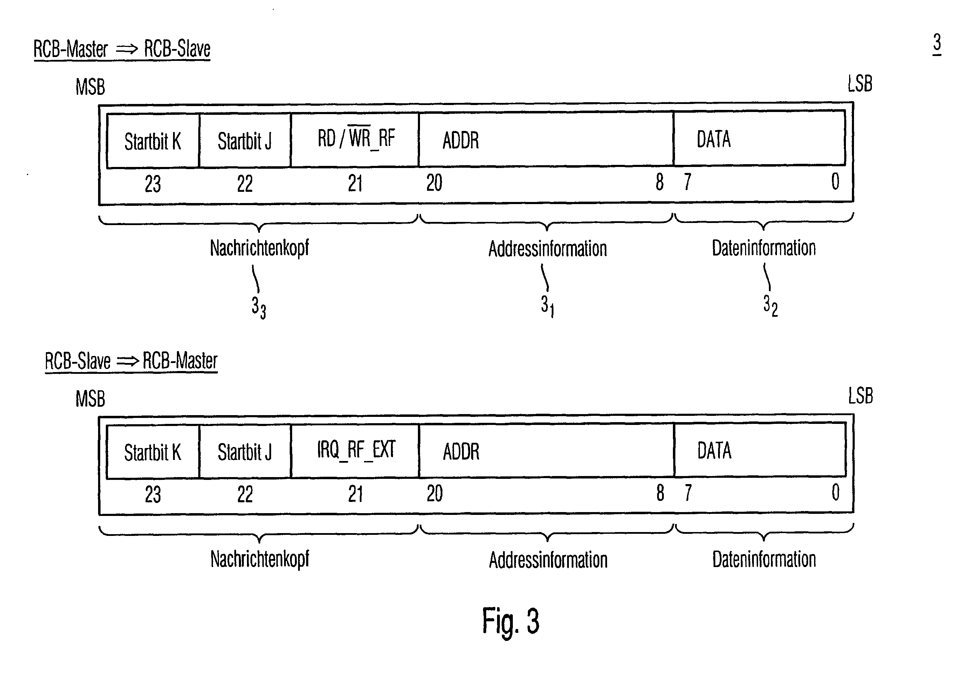

Das Standardtelegramm 3 besteht, wie in Fig. 3 gezeigt, aus einem Nachrichtenkopf 3₃, welcher durch ein Startbit 'K' gefolgt von einem Startbit 'J' und ein nachfolgendes Statusbit gebildet wird. Das Statusbit wird entweder mit den Zeichen RD/WR_RF oder IRQ_RF_EXT belegt, je nachdem ob die Übertragung von der übergeordneten Einheit an die untergeordneten Einheiten oder in entgegengesetzter Richtung stattfindet. Danach folgt ein Adress- 3₁ und ein Datenfeld 3₂. In der beispielhaft gezeigten Nachrichtenstruktur werden 13 Bits für das Adress- und 8 Bits für das Datenfeld benutzt.

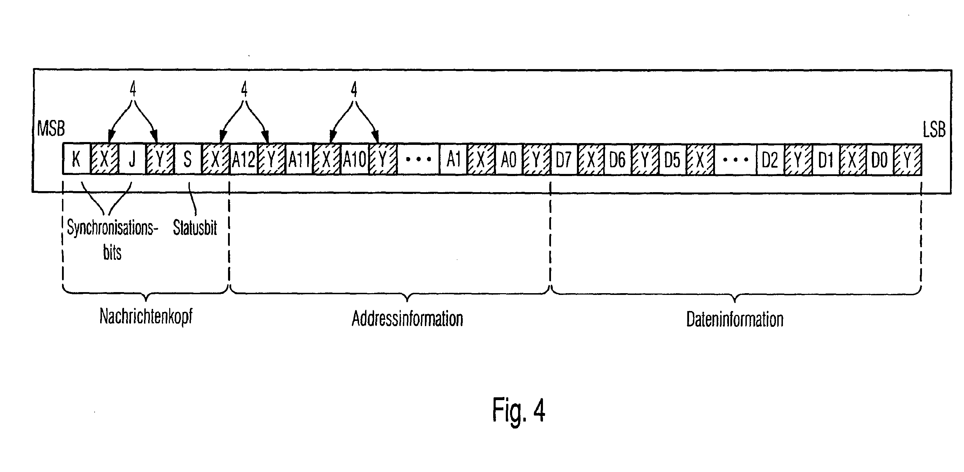

Fig. 4 zeigt die bitweise Aufteilung einer Nachricht auf die Freiplätze zwischen den Taktbits oder -zeichen. Das Taktsignal ist als alternierende Folge von Zeichen 'X' und 'Y' erkennbar. Zur Kodierung der Zeichen wird vorzugsweise ein differentieller Manchester Code, wie er nachfolgend beschrieben ist, eingesetzt. Dabei wird das Zeichen 'X' dadurch kenntlich, dass es zwischen dem ersten und zweiten Start- oder Synchronisationsbit 'K' und 'J' erscheint. Das Zeichen 'Y' ergibt sich als auf das Start- oder Synchronisationsbit 'J' folgend. Durch diese bitweise Aufteilung der Nachricht wird es möglich, Bitinformation gleichzeitig und völlig unabhängig auf dem seriellen Bus neben asynchron zwischen den Einheiten versendeten Nachrichten auszutauschen. Die wechselweise Einfügung der Zeichen 'X' und 'Y' kann sofort ausgewertet werden. Die Bitinformation, die über die ständig ausgetauschten Taktsignale übertragen wird, wird auch als zeitkritisches Signal angegeben.

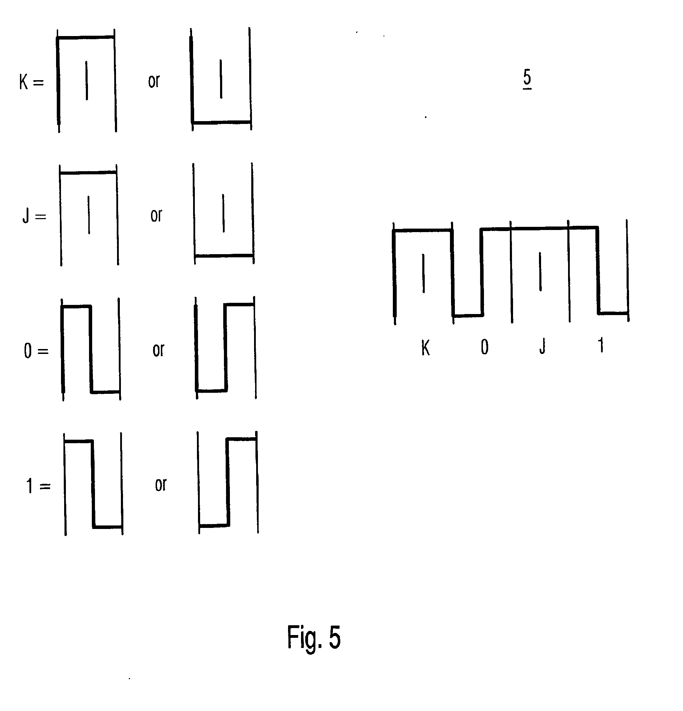

Fig. 5 zeigt den Aufbau des vorzugsweise verwendeten Manchester Kodierungsverfahrens 5. Bei dem Verfahren 5 erfolgt eine Aufteilung in Bit-Zellen, wobei in der erste Hälfte der Bit-Zelle eine andere Polarisation oder Amplitude gegeben ist als in der zweiten Hälfte der Bit-Zelle. Dadurch wird erreicht, daß in jeder Bit-Zelle ein Pegelsprung auftritt, der z.B. auch eine einfache Synchronisation der beteiligten Stationen ermöglicht. Die Unterscheidung der Zeichen erfolgt dabei durch eine Flanke am Bitbeginn. So ist das Zeichen '0' durch eine Flanke am Bitbeginn gekennzeichnet, wohingegen beim Zeichen '1' keine Flanke kodiert wird. Bei dem vorliegend vorzugsweise verwendeten Derivat des Manchester Codes werden ausserdem zwei Codeerweiterungen in das Codealphabet, d.h. die Menge der verwendeten Zeichen, aufgenommen: 'K' und 'J'. Dabei ist die Codeerweiterung dadurch gegeben, dass kein Polarisationswechsel oder Pegelsprung in der Bitmitte auftritt. Das Zeichen 'K' ist durch eine Flanke, das Zeichen 'J' durch 'keine Flanke' am Bitbeginn gekennzeichnet.

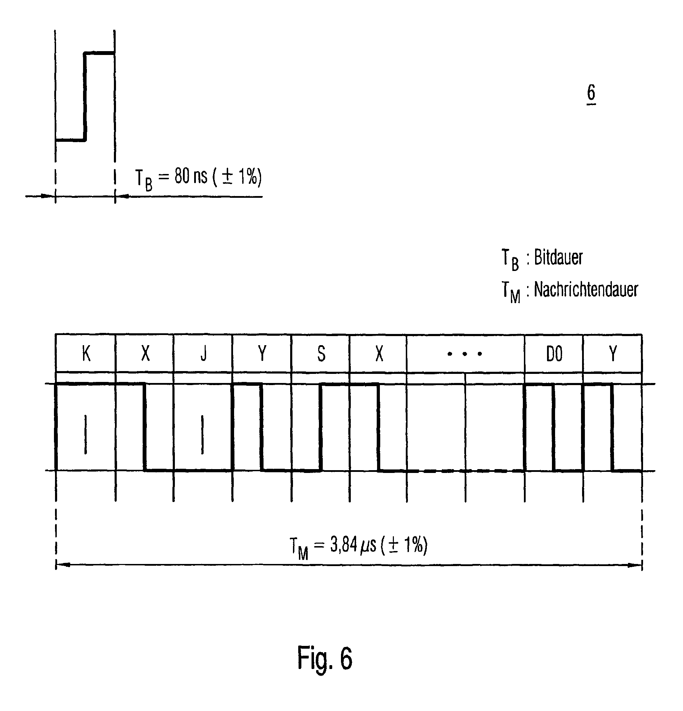

Fig. 6 zeigt das Zeitverhalten oder Timing 6 eines Nachrichtentelegramms, insbesondere auch eines zeitkritischen Nachrichtentelegramms 4. Bei einer beispielhaften Datenrate von 12,5 MHz ergibt sich pro Bit eine Zeitallokation von T_{B} = 80ns und damit für die Gesamtlänge eines zeitkritischen Telegramms T_{M} = 3,84µs (= 24 x 80ns). Dabei ist für die gesicherte Verarbeitung der Nachrichten eine Toleranzbreite von 1% vorgesehen.

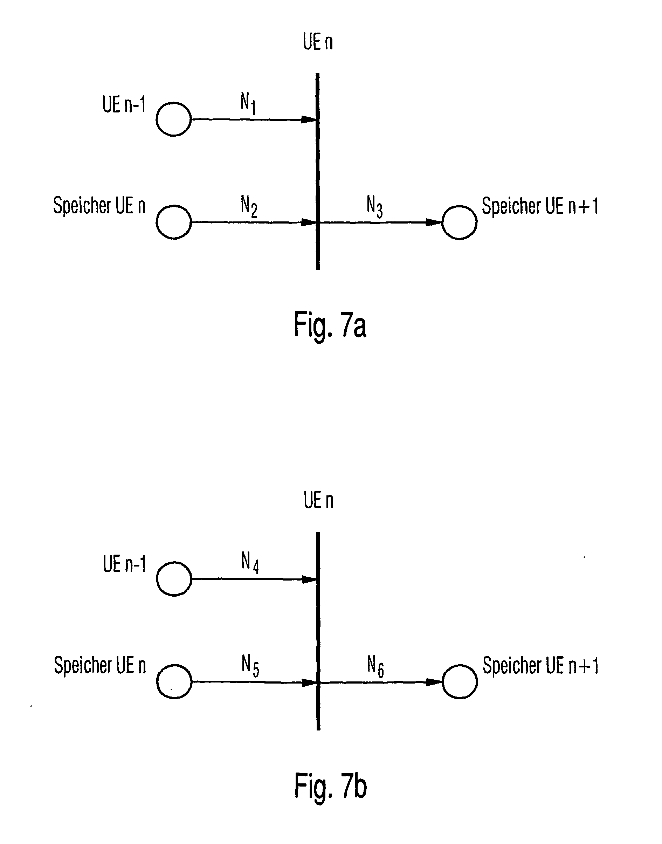

Die Standardnachrichtenverarbeitung ist in den Figuren 7a und 7b dargestellt. Fig. 7a zeigt dabei die Verarbeitung von Standardnachrichten, die mit Hilfe eines Speichers 1₂₁₁ verarbeitet werden.

Standardnachrichten 3 von der übergeordneten Einheit 1₁ an die untergeordneten Einheiten 1₂ bzw. 1₃ werden von den untergeordneten Einheiten 1₂ bzw. 1₃ gleichzeitig erhalten. Dieses Nachrichtenweitergabe wird als point-tomultipoint-Verbindung bezeichnet.

Standardnachrichten 3 werden von den untergeordneten Einheiten 1₃ an die übergeordnete Einheit 1₁ über die zwischenliegenden untergeordneten Einheiten 1₂ weitergeleitet. Dadurch wird ein reibungsloser Ablauf der Nachrichtenweitergabe einer untergeordneten Einheit 1₂ bzw. 1₃ an die übergeordnete Einheit 1₁ auf dem seriellen Bus 1₅ ermöglicht. Zugriffsprobleme entstehen nicht, da der Bus 1₅ in Richtung Zentrale 1₁ so aufgebaut ist, dass kurzfristig eine sogenannte point-to-point Verbindung zwischen jeweils zwei untergeordneten Einheiten 1₂ bzw. einer untergeordneten Einheit 1₂ und der übergeordneten Einheit 1₁ aufgebaut wird, bis eine Nachricht 3 erfolgreich an die übergeordnete Einheit 1₁ weitergeleitet wurde.

Für die Verarbeitung einer Standardnachricht 3 sind zwei Verfahrensweisen möglich. Die Figuren 7a und 7b zeigen die Funktionsweise. Fig. 7a illustriert dabei einen ersten Fall. Dabei erhält eine untergeordnete Einheit UEn über eine point-to-point Verbindung von einer untergeordneten Einheit UEn-1 eine Nachricht N₁ und prüft, dargestellt durch eine Nachricht N₂, ob der eigene Nachrichtenspeicher 1₂₁₁ leer ist. Sollte dies der Fall sein, wird eine Nachricht N₃ direkt an den Speicher der nachfolgenden untergeordneten Einheit UEn+1 weitergeleitet. Fig. 7b zeigt dabei einen zweiten Fall. Enthält der Speicher 1₂₁₁ bereits mindestens eine Nachricht, dann wird die empfangene Nachricht N₄ bis zur erfolgreichen Abarbeitung aller in dem Speicher 1₂₁₁ enthaltenen Nachrichten in dem Speicher 1₂₁₁ abgelegt und erst nach Abarbeitung der Nachrichten im Speicher als eine Nachricht N₆ an die nachfolgende untergeordnete Einheit weitergesandt UEn+1. Die Verweilzeit der Nachricht N₄ im Speicher 1₂₁₁ hängt von der initialen Anzahl der Nachrichten im Speicher 1₂₁₁ ab.

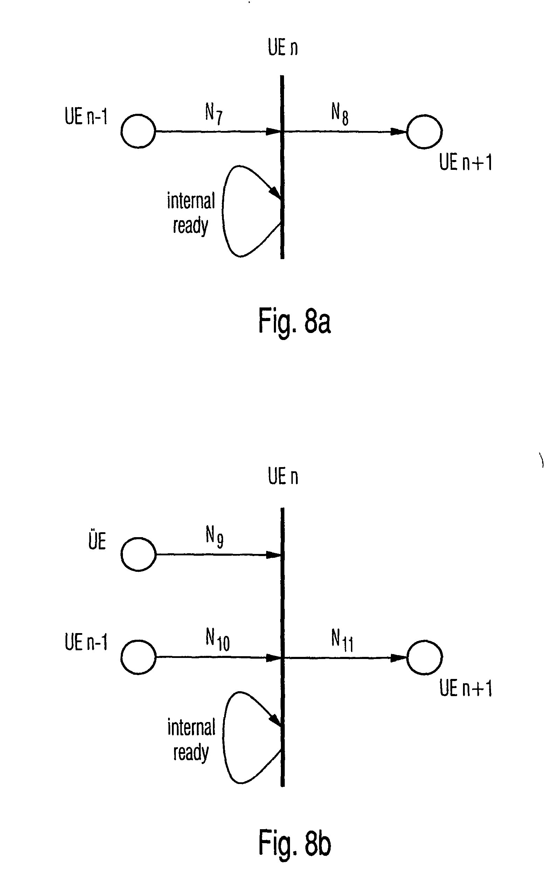

Zeitkritische Signale 4, deren Verarbeitung in den Figuren 8a und 8b dargestellt ist, werden gesendet, wenn eine gesonderte Verarbeitung und ein schneller Austausch von Nachrichten notwendig und in Form von Bitinformation möglich ist. Dies tritt dann ein, wenn z.B. ein Funkgerät als übergeordnete Einheit ÜE für die Sendung eines Hochfrequenzsignals an die untergeordneten Einheiten UE1-UE4 bestimmte Einstellungen, z.B. Verstärkungsfaktoren, Filterparameter oder Einstellungen eines Antennenanpaßgeräts, sendet und kurz vor dem Sendebeginn eine Bestätigung über die erfolgreiche Einstellung der notwendigen Parameter fordert, um daraufhin das HF-Signal aussenden zu können. Die Bestätigungen werden dann in Form eines zeitkritischen Signals 4 von den untergeordneten Einheiten UE1-UE4 an die übergeordnete Einheit ÜE gesendet. Dies erfolgt so, dass das letzte Glied UE1 des Busses 1₅ als erstes die Kodierung seines Taktsignals ändert. Im Gegensatz zu Standardnachrichten erfahren zeitkritische Signale in den zu durchlaufenden untergeordneten Einheiten eine gesonderte Verarbeitung.

Fig. 8a zeigt eine erste allgemeine Darstellungsweise. Trifft an einer untergeordneten Einheit 1₂ aufgrund einer vorausgehenden Nachricht zur HF-Übertragung der übergeordneten Einheit an alle oder nur einige der untergeordneten Einheiten UE1-UE4 z. B. an der untergeordneten Einheit UE3 ein zeitkritisches Signal 4, in der Fig. 8a mit N₇ bezeichnet, einer vorherigen Einheit UE2 ein, so wird zunächst ein interner Zustand READY geprüft und das Signal 4, dann als zeitkritische Sammelnachricht N₈ an die nachfolgende untergeordnete Einheit UE3 oder im Falle der letzten untergeordneten Einheit UE4 an die übergeordnete Einheit ÜE weitergesendet.

Fig. 8b zeigt die Verarbeitung für den Fall des speziellen TX_ACTIVE Signals 10₁, die auf eine bevorstehende HF-Signalübertragung hinweist. Bei dieser Variante wird von allen untergeordneten Einheiten UE1-UE4 ein READY-Signal 10₃ erwartet und dieses von untergeordneter Einheit z. B. UE3 zu untergeordneter Einheit UE4 und dann zur übergeordneten Einheit ÜE weitergeleitet.

Die Kommunikation verläuft dabei so, dass die übergeordnete Einheit ÜE ein Signal N₉ an eine untergeordnete Einheit UEn sendet. Diese setzt einen internen Zustand auf READY und wartet auf ein Signal N₁₀ von einer im Bus 1₅ vorhergehenden untergeordneten Einheit UEn-1. Nach Abfrage des internen Zustandes, wird dann ein verknüpftes Signal N₁₁ an eine nachfolgende untergeordnete Einheit UEn+1 gesandt.

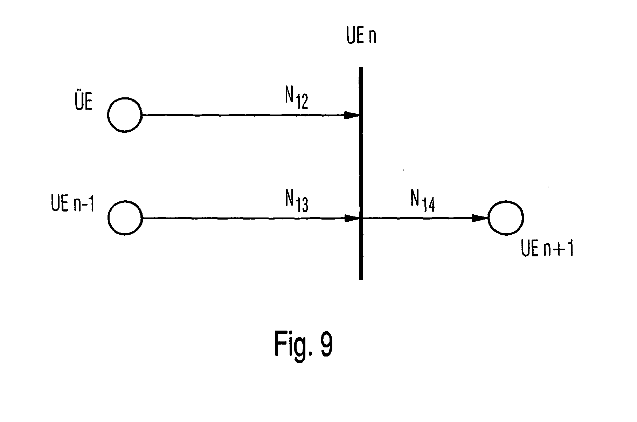

Fig. 9 zeigt einen weiteren Signalverarbeitungsablauf. Es wird ein Signal N₁₂ von einer übergeordneten Einheit ÜE von einer untergeordenten Einheit UEn empfangen. Bei einer Anwendung des Busses 1₅ betrifft dies den Empfang eines TX_ACTIVE/ CARRIER_MAGNITUDE Signals, welches den unmittelbaren Sendebetrieb kennzeichnet. Daraufhin wird ggf. ein interner Zustand gesetzt, in der Figur nicht gezeigt. Wird danach von einer vorausgehenden untergeordneten Einheit UEn-1 ein Signal N₁₃ erhalten, wird ein Signal N₁₄ erzeugt und an eine nachfolgende untergeordnete Einheit 1₂ weitergesendet.

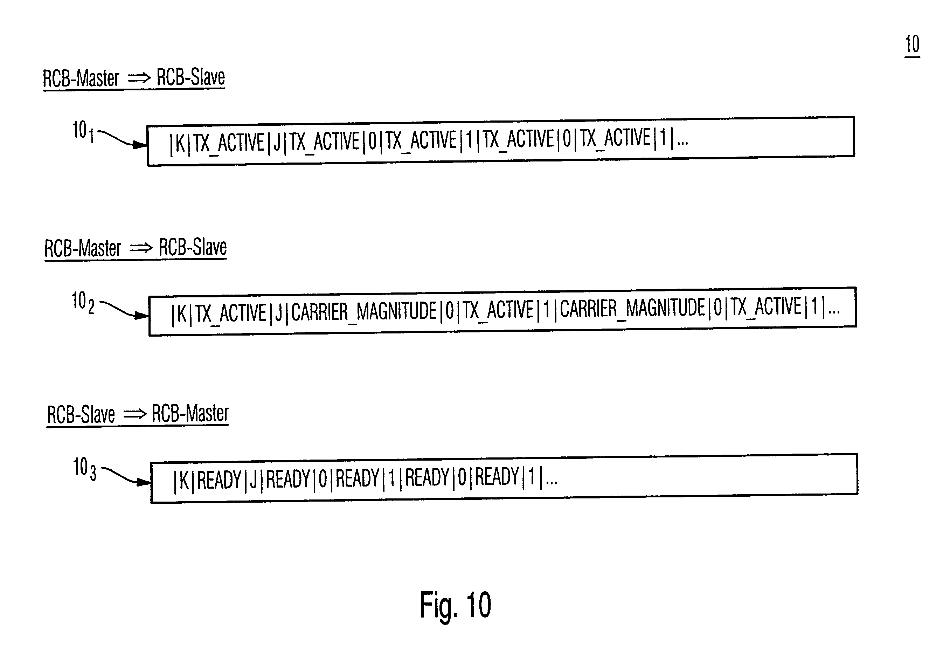

Fig. 10 zeigt drei spezielle Signale insbesondere zeitkritische Signale 10₁, 10₂. und 10₃, die von der übergeordneten Einheit ÜE zu den untergeordneten Einheiten UE1-UE4 sowie von den untergeordneten Einheiten UE1-UE4 zur Zentrale ÜE gesendet werden. Dabei ist ein erstes Signal 10₁ von der übergeordneten Einheit ÜE an alle untergeordnete Einheiten UE1-UE4 **dadurch gekennzeichnet, dass** es als Taktsignal als ständige Folge von Zeichen 'X' kodiert ist. Die Figur 10 zeigt wieder den parallelen Austausch von echtzeitfähiger Bitinformation und längeren Datenpaketen. Das Zeichen TX_ACTIVE ist **dadurch gekennzeichnet, dass** es als Signal 10₁ von der übergeordneten Einheit ÜE an die untergeordneten Einheiten UE1-UE4 gesendet wird. Ein zweites Signal 10₂ von der übergeordneten Einheit ÜE zu den untergeordneten Einheiten UE1-UE4 wird ebenfalls mit Hilfe des Taktsignals übermittelt, jedoch werden abwechselnd TX_ACTIVE und CARRIER_MAGNITUDE gesendet. Dabei wird CARRIER_MAGNITUDE als 'Y' übertragen. Ein vorauslaufender Sync-Frame sorgt wieder für einen Abgleich der Taktgeneratoren. Bei einem READY-Signal 10₃ der untergeordneten Einheiten UE1-UE4 an die übergeordnete Einheit ÜE wird ein READY-Signal gesendet, wie oben beschrieben.

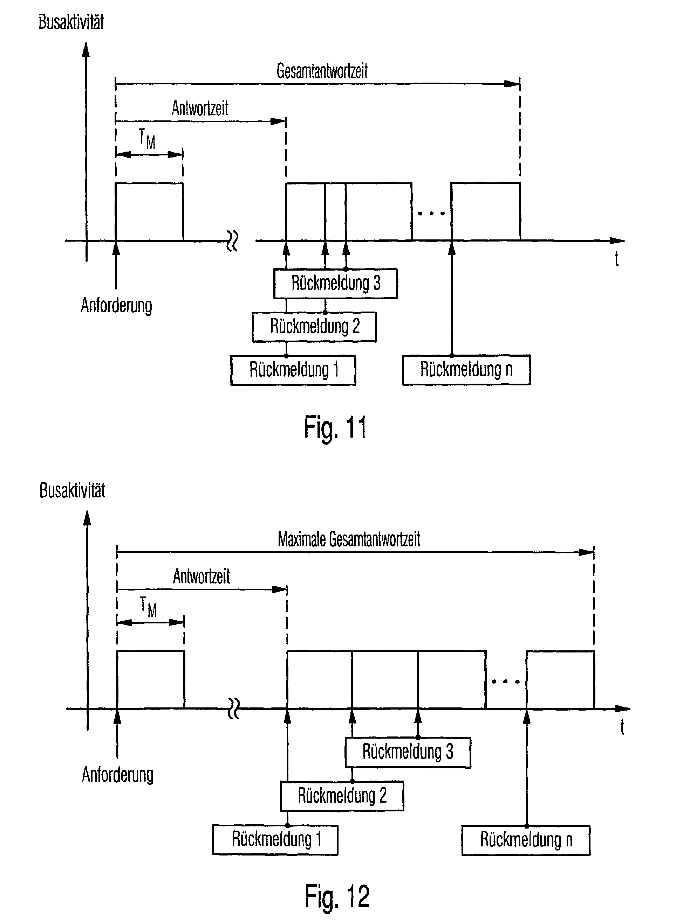

Die Figuren 11 und 12 geben in Form von Zeit-Diagrammen einen Überblick des zeitlichen Ablaufs der Busaktivität zur Weiterreichung zeitkritischer Signale über die verbundenen untergeordneten Einheiten UE1-UE4 bis zur übergeordneten Einheit ÜE am Bus 1₅. Nach einer Aufforderung der übergeordneten Einheit ÜE der Länge T_{M} und einer vorbestimmten Antwortzeit der letzten oder abschliessenden untergeordneten Einheit UE1 am Bus wird das Signal über den Abschluß der Parametereinstellungen in den untergeordneten Einheiten nach dem obenbeschriebenen point-to-point Signalisierungsverfahren von untergeordneter Einheit UEn-1 zu untergeordneter Einheit UEn und schließlich an die übergeordnete Einheit ÜE weitergeleitet. Die Gesamtantwortzeit ergibt sich dann wie in Fig. 11 gezeigt. Fig. 12 zeigt die Verhältnisse für den Fall, dass eine volle Nachrichtendauer zur Auswertung des internen Zustands benötigt wird.

Die Erfindung ist nicht auf die beschriebenen Ausführungsbeispiele beschränkt. Das erfindungsgemäße Bussystem kann vielfältig zum Einsatz kommen. Alle beschriebenen und gezeichneten Elemente sind beliebig miteinander kombinierbar.

## Patentansprüche

1. Bussystem (1) zur Echtzeitkommunikation einer übergeordneten Einheit (1₁) mit einer oder mehreren untergeordneten Einheiten (1₂,1₃), welches geeignet ist Adress- und Dateninformation über einen Bus (1₅) auszutauschen und bei dem zum Austausch von Nachrichten zwischen Feldern (4₂,4₃), die für die Adress- und Dateninformation geeignet sind, weitere Felder (4₄) vorgesehen sind,
**dadurch gekennzeichnet,**
**dass** ein Kopf (4₁) eines Datenblocks mehrere Synchronisationsfelder (4₅) und zumindest ein Feld (4₆) zur Anzeige eines Nachrichtenstatus umfasst, die den Feldern (4₂, 4₃) der Adress- und der Dateninformation vorangestellt sind, wobei die Dateninformation (4₃) der Adressinformation (4₂) folgt und
**dass** in den Feldern (4₂,4₃,4₅,4₆), die die Adress-, Daten-, Synchronisations- und Statusinformation beinhalten, zum Austausch von Nachrichten nach jedem einzelnen Zeichen des Datenblocks ein weiteres Feld (4₄) vorgesehen ist, das ein weiteres Zeichen fassen kann und diese Felder abwechselnd durch Zeichen 'X' und 'Y' belegt sind.

2. Bussystem nach Anspruch 1,
**dadurch gekennzeichnet,**
**dass** die Felder (4₄) zum Austausch von Nachrichten alternierend mit den Feldern (4₂,4₃) für die Adress- und Dateninformation angeordnet sind.

3. Bussystem nach Anspruch 1 oder 2,
**dadurch gekennzeichnet,**
**dass** der Datenblock (4) aus 48 Felder besteht, wobei die Felder (4₂,4₃,4₅,4₆), die die Adress-, Daten-, Synchronisations- und Statusinformation beinhalten, durch je 13, 8, 2 bzw. 1 Zeichen dargestellt werden.

4. Bussystem nach Anspruch 3,
**dadurch gekennzeichnet,**
**dass** die Felder (4₂,4₃,4₄,4₅,4₆) durch je ein Bit kodiert sind und damit die Synchronisationsfelder (4₅), das Statusfeld (4₆), die Adress- (4₂) bzw. Dateninformation (4₃) durch 2, 1, 13 bzw. 8 Bits dargestellt sind.

5. Bussystem nach einem der Ansprüche 1 bis 4,
**dadurch gekennzeichnet,**
**dass** jede untergeordnete Einheit (1₂,1₃) mit einem Speicher (1₂₁₁) ausgestattet ist und die untergeordneten Einheiten (1₂) die übergeordneten Einheit (1₁) und eine abschließende untergeordnete Einheit (1₃) über den Bus (1₅) verbinden.

6. Bussystem nach einem der Ansprüche 1 bis 4,
**dadurch gekennzeichnet,**
**dass** die Signal- oder Nachrichtenübertragung der Datenblöcke (4) auf dem Bus (1₅) über Koaxial- oder Glasfaserverkabelung (1₄) erfolgt.

7. Bussystem nach Anspruch 4,
**dadurch gekennzeichnet,**
**dass** die Bitkodierung durch einen differentiellen Manchester Code (5) erfolgt.

8. Bussystem nach Anspruch 1 bis 7,
**dadurch gekennzeichnet,**
**dass** die übergeordnete Einheit (1₁) ein Funkgerät (2₁) ist und die untergeordneten Einheiten ein oder mehrere Zusatzgeräte (2₂,2₃) sind.

9. Bussystem nach Anspruch 8,
**dadurch gekennzeichnet,**
**dass** die Zusatzgeräte (2₂) ein Verstärker, ein Stehwellenmeßgerät, Frequenzselektoren und/oder ein automatisches Antennenanpaßgerät (2₃) sind.

## Claims

1. Bus system (1) for the realtime communication of a superordinate unit (1₁) with one or more subordinate units (1₂, 1₃), which is suitable for exchanging address and data information via a bus (1₅), and in which further fields (4₄) are provided for the exchange of messages between fields (4₂, 4₃), which are suitable for the address and data information,
**characterised in that**
a header (4₁) of a data block comprises several synchronisation fields (4₅) and at least one field (4₆) for the display of a message status, which are located in front of the fields (4₂, 4₃) of the address and the data information, wherein the data information (4₃) follows the address information (4₂) and
that, in the fields (4₂, 4₃, 4₅, 4₆), which contain the address, data, synchronisation and status information, a further field (4₄), which can contain one further character, is provided after every individual character of the data block for the exchange of messages, and these fields are defined in alternation by the characters 'X' and 'Y'.

2. Bus system according to claim 1,
**characterised in that**
the fields (4₄) for the exchange of messages are arranged in alternation with the fields (4₂, 4₃) for the address and data information.

3. Bus system according to claim 1 or 2,
**characterised in that**
the data block (4) consists of 48 fields, wherein the fields (4₂, 4₃, 4₅, 4₆), which contain the address, data, synchronisation and status information, are presented in each case by 13, 8, 2 or 1 characters.

4. Bus system according to claim 3,
**characterised in that**
the fields (4₂, 4₃, 4₄, 4₅, 4₆) are coded in each case by one bit, and accordingly, the synchronisation fields (4₅), the status field (4₆), the address information (4₂) and respectively data information (4₃) are presented by 2, 1, 13 and respectively 8 bits.

5. Bus system according to any one of claims 1 to 4,
**characterised in that**
each subordinate unit (1₂, 1₃) is fitted with a buffer (1₂₁₁) and the subordinate units (1₂) connect the superordinate unit (1₁) and a terminal subordinate unit (1₃) via the bus (1₅).

6. Bus system according to any one of claims 1 to 4,
**characterised in that**
the signal or message transmission of the data blocks (4) on the bus (1₅) is implemented via coaxial or fibre-optic cabling (1₄).

7. Bus system according to claim 4,
**characterised in that**
the bit coding is implemented through a differential Manchester code (5).

8. Bus system according to claim 1 to 7,
**characterised in that**
the superordinate unit (1₁) is a radio device (2₁), and the subordinate units are one or more supplementary devices (2₂, 2₃).

9. Bus system according to claim 8,
**characterised in that**
the supplementary devices (2₂) are an amplifier, a standing-wave measuring instrument, frequency selectors and/or an automatic Antenna Tuning Unit (2₃).

## Revendications

1. Système de bus (1) pour la communication en temps réel d'une unité maître (1₁) avec une ou plusieurs unités subordonnées (1₂, 1₃), lequel système étant apte à échanger des informations d'adresses et de données sur un bus (1₅) et pour lequel afin d'échanger des messages entre des champs (4₂, 4₃), qui conviennent pour les informations d'adresses et de données, il est prévu d'autres champs (4₄),
**caractérisé,**
**en ce qu**'un en-tête (4₁) d'un bloc de données comporte plusieurs champs de synchronisation (4₅) et au moins un champ (4₆) pour afficher un état de message, qui sont placés avant les champs (4₂, 4₃) des informations d'adresses et de données, l'information de données (4₃) suivant l'information d'adresses (4₂) et
en ce que dans les champs (4₂, 4₃, 4₅, 4₆), qui contiennent les informations d'adresses, de données, de synchronisation et d'état, pour échanger des messages selon chaque caractère particulier du bloc de données, il est prévu un autre champ (4₄) qui peut comporter un autre caractère et ces champs sont occupés en alternance par des caractères 'X' et 'Y'.

2. Système de bus selon la revendication 1, **caractérisé en ce que,**
les champs (4₄) pour échanger des messages sont disposés en alternance avec les champs (4₂, 4₃) pour les informations d'adresses et de données.

3. Système de bus selon la revendication 1 ou 2, **caractérisé en ce que,**
le bloc de données (4) se compose de 48 champs, les champs (4₂, 4₃, 4₅, 4₆), qui contiennent les informations d'adresses, de données, de synchronisation et d'état, étant représentés respectivement par 13, 8, 2 ou 1 caractères.

4. Système de bus selon la revendication 3, **caractérisé en ce que**
les champs (4₂, 4₃, 4₄, 4₅, 4₆) sont codés chacun par un bit et qu'ainsi les champs de synchronisation (4₅), le champ d'état (4₆), l'information d'adresses (4₂) et l'information de données (4₃) sont représentés respectivement par 2, 1, 13 et 8 bits.

5. Système de bus selon l'une quelconque des revendications 1 à 4, **caractérisé en ce que,**
chaque unité subordonnée (1₂, 1₃) est pourvue d'une mémoire (1₂₁₁) et **en ce que** les unités subordonnées (1₂) relient l'unité maître (1₁) et une unité subordonnée finale (1₃) par le biais du bus (1₅).

6. Système de bus selon l'une quelconque des revendications 1 à 4, **caractérisé en ce que,**
la transmission de signal ou de message des blocs de données (4) s'effectue sur le bus (1₅) par un câblage coaxial ou un câblage en fibre de verre (1₄).

7. Système de bus selon la revendication 4, **caractérisé en ce que,**
le codage des bits est effectué selon un code de Manchester (5) différentiel.

8. Système de bus selon la revendication 1 à 7, **caractérisé en ce que,**
l'unité maître (1₁) est un appareil de radiocommunication (2₁) et que les unités subordonnées sont un ou plusieurs appareils auxiliaires (2₂, 2₃).

9. Système de bus selon la revendication 8, **caractérisé en ce que,**
les appareils auxiliaires (2_{z}) sont un amplificateur, un appareil de mesure d'ondes stationnaires, des sélecteurs de fréquence et/ou un appareil automatique d'adaptation d'antenne (2₃).
